(19) Europäisches Patentamt
European Patent Office
Office européen des brevets

(11) **EP 4 808 333 A2**

(12) **EUROPEAN PATENT APPLICATION**

(43) Date of publication:
**16.09.2026 Bulletin 2026/38**

(21) Application number: **26195252.7**

(22) Date of filing: **26.02.2025**

(51) International Patent Classification (IPC):
***H10K 59/80*** *(2023.01)*

(52) Cooperative Patent Classification (CPC):
**H10K 59/122; H10K 59/124; H10K 59/126; H10K 59/352; H10K 59/873; H10K 59/8792**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **29.02.2024 KR 20240029853**

(62) Document number(s) of the earlier application(s) in accordance with Art. 76 EPC:
**25160250.4 / 4 611 514**

(71) Applicant: **LG Display Co., Ltd.**
**Seoul 07336 (KR)**

(72) Inventors:
- **CHOI, Sun Young**
  **10845 Paju-si (KR)**
- **SHIN, Dong Chae**
  **10845 Paju-si (KR)**
- **JEONG, Mi Jin**
  **10845 Paju-si (KR)**

(74) Representative: **Kilburn & Strode LLP**
**Lacon London**
**84 Theobalds Road**
**Holborn**
**London WC1X 8NL (GB)**

Remarks:
This application was filed on 29.07.2026 as a divisional application to the application mentioned under INID code 62.

(54) **LIGHT EMITTING DISPLAY DEVICE**

(57) Disclosed is a light emitting display device including a substrate including a first area and a second area, a first light shielding pixel-defining film provided in the first area, exposing a first blue light emitting portion, a first green light emitting portion, and a first red light emitting portion, and having a first height, a second light shielding pixel-defining film provided in the second area, including a region exposing a second blue light emitting portion, a second green light emitting portion, and a second red light emitting portion and a light transmitting portion, and including an area having a second height smaller than the first height, and a light emitting element provided on the first blue light emitting portion, the first green light emitting portion, the first red light emitting portion, the second blue light emitting portion, the second green light emitting portion, and the second red light emitting portion.

EP 4 808 333 A2

## Description

This application claims the benefit of Korean Patent Application No. 10-2024-0029853, filed on February 29, 2024.

## BACKGROUND OF THE INVENTION

### Field of the Invention

The present disclosure relates to a display device, and more specifically, to a light emitting display device including a transistor to improve brightness and reliability.

### Discussion of the Related Art

Display devices for displaying images in TVs, monitors, mobile phones, tablet computers, and laptops are used in various modes and configurations.

A display device includes a plurality of pixels to form an image and a plurality of transistors to control the operation of each pixel.

A display device includes a plurality of pixels and is provided with a plurality of driving and switching elements to drive and control the pixels. The driving and switching elements may include transistors and the transistors are widely applied to integrated circuits as well as to pixels.

Recently, various research and development efforts have been conducted to improve the performance and reliability of transistors.

## SUMMARY OF THE INVENTION

Accordingly, the disclosure is directed to a light emitting display device that substantially obviates one or more problems due to the limitations and disadvantages of the related art.

It is one object of the present disclosure to provide a light emitting display device that exhibits improved brightness based on structural change in an area where light emitting portions and light transmitting portions are mixed.

It is another object of the present disclosure to provide a light emitting display device that is capable of shielding not only upper light but also internally scattered light based on a light shielding pixel-defining film disposed around a light emitting portion in transistors including an active layer of a high-mobility oxide semiconductor.

It is another object of the present disclosure to provide a light emitting display device that is capable of preventing the influence of light from a light emitting element in a structure including an active layer of a high-mobility oxide semiconductor, and in particular, is capable of preventing the difference in influence of the active layer caused by the difference in wavelength of light through the difference in height of the light shielding pixel-defining film.

It is another object of the present disclosure to provide a light emitting display device that is capable of blocking light generated from an adjacent light emitting element from being transmitted to a light transmitting portion based on a light shielding pixel-defining film disposed around the light transmitting portion.

It is another object of the present disclosure to provide a light emitting display device that is capable of preventing a rapid change in brightness through a gradual thickness change of a light shielding pixel-defining film at the boundary between a light emitting portion and a light transmitting portion.

It is another object of the present disclosure to provide a light emitting display device that is capable of improving optical reliability, forming active patterns having different structures in the same process, reducing the amounts of materials used throughout the manufacturing process, such as gases and etchants, for manufacturing display devices, and reducing generation of greenhouse gases in the manufacturing process, thereby realizing process optimization.

Additional advantages, objects, and features of the disclosure will be set forth in part in the description which follows and in part will become apparent to those having ordinary skill in the art upon examination of the following, or may be learned from practice of the disclosure. The objectives and other advantages of the disclosure may be realized and attained by the structure particularly pointed out in the written description and claims hereof as well as the appended drawings.

A light emitting display device according to one example of the present disclosure is set out in the appended claims.

It is to be understood that both the foregoing general description and the following detailed description of the disclosure are exemplary and explanatory and are intended to provide further explanation of the disclosure as claimed.

## BRIEF DESCRIPTION OF THE DRAWINGS

The accompanying drawings, which are included to provide a further understanding of the disclosure and are incorporated in and constitute a part of this application, illustrate example(s) of the disclosure and together with the description serve to explain the principle of the disclosure. In the drawings:

FIG. 1 is a schematic plan view illustrating a light emitting display device according to one example of the present disclosure;
FIG. 2 is a circuit diagram illustrating a sub-pixel according to one example of the present disclosure;
FIG. 3 is an enlarged view of area A of FIG. 1;
FIG. 4 is a cross-sectional view taken along line I-I' of a second area of FIG. 3 and a part of a first area of FIG. 3 according to the first example of the present disclosure;
FIG. 5 is a cross-sectional view illustrating transistors of a sub-pixel according to a first example of the present disclosure;
FIG. 6 is a cross-sectional illustrating a light emitting display device according to a second example of the present disclosure; and
FIG. 7 is a cross-sectional view illustrating a light emitting display device according to a third example of the present disclosure.

## DETAILED DESCRIPTION OF THE INVENTION

Hereinafter, preferred examples of the present disclosure will be described with reference to the attached drawings. In the following description of the present disclosure, where the detailed description of the relevant known steps, elements, functions, technologies, and configurations can unnecessarily obscure an important point of the present disclosure, a detailed description of such steps, elements, functions, technologies, and configurations may be omitted. In addition, the names of elements used in the following description are selected in consideration of clarity of description of the specification, and can differ from the names of elements of actual products.

The shapes, sizes, ratios, angles, numbers, and the like, which are illustrated in the drawings to describe various example examples of the present disclosure are merely given by way of example. The disclosure is not limited to the illustrations in the drawings. In the present disclosure, where terms such as "including," "having," "comprising," and the like are used, one or more components can be added, unless the term, such as "only," is used. The terminology used herein is to describe particular aspects and is not intended to limit the present disclosure. As used herein, the terms "a" and "an" used to describe an element in the singular form is intended to include a plurality of elements. An element described in the singular form is intended to include a plurality of elements, and vice versa, unless the context clearly indicates otherwise.

In construing a component or numerical value, the component or the numerical value is to be construed as including an error or tolerance range even where no explicit description of such an error or tolerance range is provided.

In describing the various example examples of the present disclosure, where the positional relationship between two elements is described using terms, such as "on", "above", "under" and "next to", at least one intervening element can be present between the two elements, unless "immediate(ly)" or "direct(ly)" or "close(ly) is used. It will be understood that when an element or layer is referred to as being "connected to", or "coupled to" another element or layer, it can be directly connected to or coupled to the other element or layer, or one or more intervening elements or layers can be present.

In describing the various example examples of the present disclosure, when terms such as "after," "subsequently," "next," and "before," are used to describe the temporal relationship between two events, another event can occur therebetween, unless a more limiting term, such as "just," "immediate(ly)," or "directly" is used.

In describing the various example examples of the present disclosure, terms such as "first" and "second" can be used to describe a variety of components. These terms aim to distinguish the same or similar components from one another and do not limit the components. Accordingly, throughout the specification, a "first" component can be the same as a "second" component within the technical concept of the present disclosure, unless specifically mentioned otherwise.

Features of various examples of the present disclosure can be partially or overall coupled to or combined with each other, and can be variously inter-operated with each other and driven technically as those skilled in the art can sufficiently understand. The examples of the present disclosure can be carried out independently from each other, or can be carried out together in a co-dependent relationship.

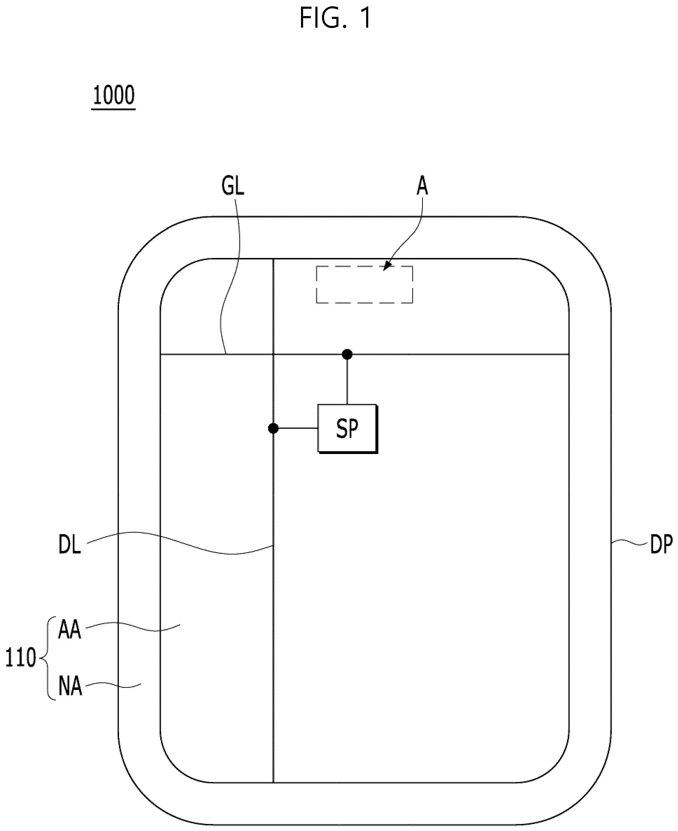

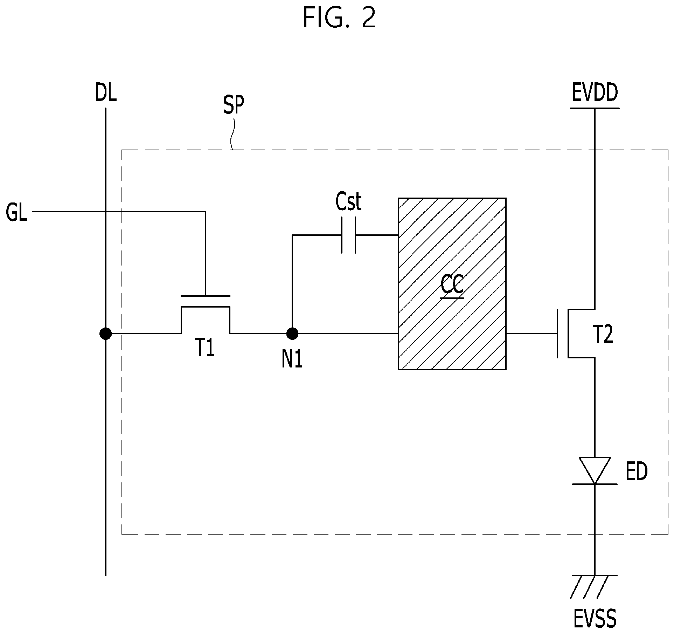

FIG. 1 is a schematic plan view illustrating a light emitting display device according to an example of the present disclosure. FIG. 2 is a circuit diagram illustrating a sub-pixel according to an example of the present disclosure.

Referring to FIGS. 1 and 2, a light emitting display device 1000 according to an example of the present disclosure may include a display panel DP and a case (not shown) that accommodates a side portion of the display panel DP and a lower portion of the display panel DP. A non-display area NA of the display panel DP may be covered by the case or by a separate light shielding film. A printed circuit film and/or a battery may be included between the lower portion of the display

panel DP and the case.

The display panel DP may include a substrate 110 including a display area AA and a non-display area NA surrounding the display area AA, and a driver connected to the substrate 110. The driver may be integrated in the substrate 110 along with the configuration in the array provided in the display area AA, or may be connected to the substrate 110 in a COG (chip on glass) manner, or may be connected to a printed circuit board via a film or connector in a COF (chip on film) manner on the substrate 110. Alternatively, the driver may include both the configuration integrated in the substrate 110 and the external configuration of the COG or COF.

The display area AA is an area that displays an image. A plurality of sub-pixels SP is disposed in the display area AA of the display panel DP, and an image may be displayed using the plurality of sub-pixels SP. The area other than the display area AA may be the non-display area NA.

The non-display area NA may be disposed in an edge area surrounding the display area AA that displays the image. At least one driver for driving a plurality of sub-pixels SP may be disposed in the non-display area NA. The driver may include a gate-in-panel GIP. The gate in panel GIP may be connected to a plurality of gate lines GL of a display area AA and may sequentially supply gate voltage signals to the plurality of gate lines GL.

Various additional elements may be further disposed in the non-display area NA to drive the sub-pixels SP in the display area AA.

Among the pixels, at least one sub-pixel SP includes a first transistor T1, a second transistor T2, a storage capacitor Cst, a compensation circuit CC, and a light emitting element ED, as shown in FIG. 2.

For example, the first transistor T1 may be a switching transistor and the second transistor T2 may be a driving transistor.

The first electrode (e.g., drain electrode) of the first transistor T1 is electrically connected to the data line DL, and the second electrode (e.g., source electrode) is electrically connected to the first node N1. The gate electrode of the first transistor T1 is electrically connected to the gate line GL. The first transistor T1 transmits the data signal supplied through the data line DL to the first node N1 in response to the scan signal supplied through the gate line GL.

The storage capacitor Cst is electrically connected to the first node N1 and charges the voltage applied to the first node N1.

The first electrode (e.g., drain electrode) of the second transistor T2 receives a high potential driving voltage (EVDD), and the second electrode (e.g., source electrode) is electrically connected to the first electrode (e.g., an anode) of the light emitting element ED. A second electrode (e.g., a cathode) of the light emitting element ED is connected to a low potential voltage (EVSS), e.g., ground. The second transistor T2 may control the amount of driving current flowing through the light emitting element ED in response to the difference in voltage between the gate electrode and the source electrode.

The semiconductor layer of the first transistor T1 and/or the second transistor T2 may contain silicon such as amorphous silicon (a-Si), polycrystalline silicon (poly-Si), or low-temperature polycrystalline silicon (poly-Si), or may contain an oxide semiconductor material.

The transistors and display devices of the examples of the present disclosure includes an oxide semiconductor layer in at least one of the transistors formed on the substrate 110 and thus are advantageously formed at a relatively low temperature compared to other materials, maintain amorphous characteristics, and have high mobility.

Meanwhile, the light emitting element ED outputs light corresponding to the driving current. The light emitting element ED may output any one of red, green, blue, and white light.

The light emitting element ED may include an anode, an intermediate layer disposed on the anode, and a cathode supplying a common voltage. The intermediate layer includes at least one light emitting layer, and when an electric field is formed between the anode and the cathode, the intermediate layer may be implemented to emit light of the same color for each pixel, such as white light, or may be implemented to emit different colors for each sub-pixel SP, such as red, green, or blue light. The intermediate layer may include various types of common layers and functional layers to efficiently supply holes and electrons to the light emitting layer, in addition to the light emitting layer.

The light emitting element ED may be a front-emitting diode or a back-emitting diode.

The compensation circuit CC may be further provided in the sub-pixel SP to compensate for the threshold voltage of the second transistor T2. The compensation circuit CC may include one or more transistors. The compensation circuit CC may include at least one transistor and capacitor, and may be configured in various configurations depending on the compensation method. The sub-pixel SP including the compensation circuit CC may include circuits having various structures with different numbers of transistors and/or capacitors such as 3T1C, 4T2C, 5T2C, 6T1C, 6T2C, 7T1C, and 7T2C.

Among the transistors provided in the sub-pixel, the switching transistor may require high-speed driving for fast switching operation. The driving transistor may supply high current to the light emitting element and require high current output for high brightness expression.

The non-display area NA may include a gate in panel GIP. The gate in panel GIP, for example, outputs gate signals to gate lines in response to a gate control signal input from a timing controller. The gate in panel GIP may include a plurality of transistors, and the plurality of transistors may be formed in the same process as the transistors of the sub-pixel

SP.

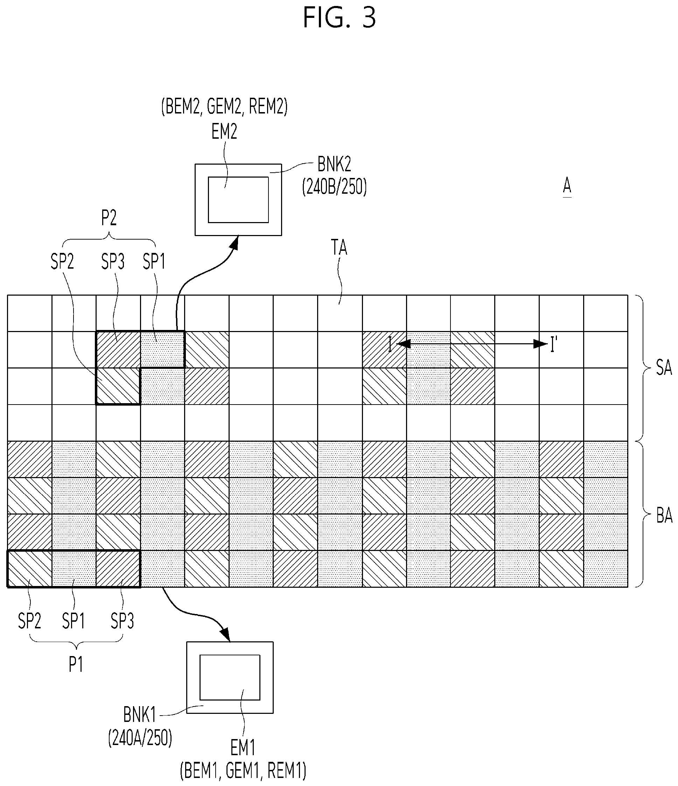

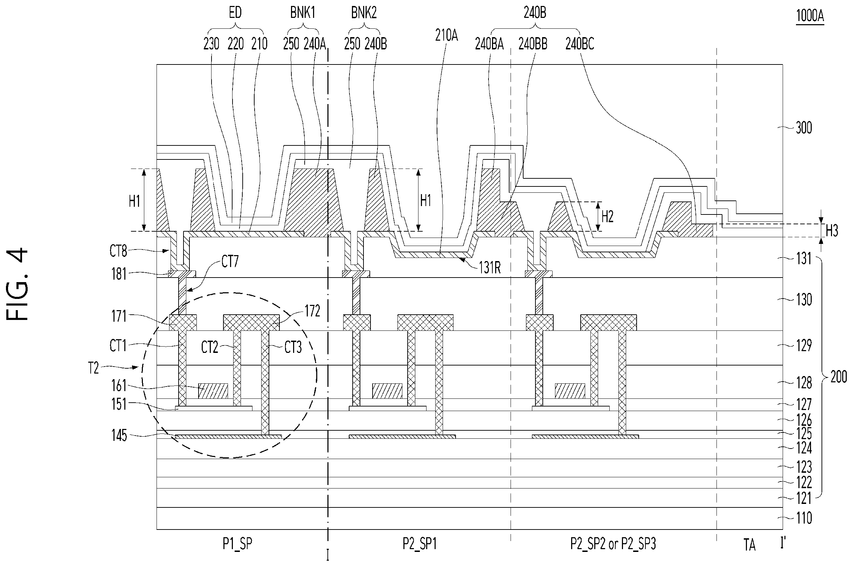

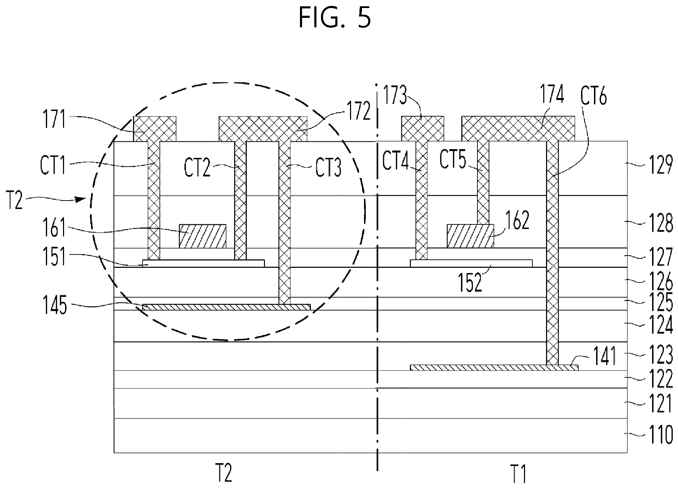

FIG. 3 is an enlarged view of area A of FIG. 1. FIG. 4 is a cross-sectional view along line I-I' of a second area of FIG. 3 and a part of a first area of FIG. 3 according to a first example of the present disclosure. FIG. 5 is a cross-sectional view illustrating transistors of a sub-pixel according to the first example of the present disclosure.

The display panel DP may be provided with a camera or sensor on the lower side of the substrate 110, as shown in the area A of FIG. 1. The camera or sensor may overlap the substrate 110 and may be provided on the lower side of the substrate 110. As shown in FIG. 1, the area A is included in the display area AA.

Referring to FIG. 3, the area A includes a first area BA in which sub-pixels SP1, SP2 and SP3 are regularly disposed at a first disposition density, and a second area SA in which a camera or sensor is provided and a light transmitting portion TA is further provided for receiving light from the camera or sensor or transmitting light from above to the camera or sensor, and thus the sub-pixels SP1, SP2 and SP3 are disposed at a second disposition density lower than the first disposition density.

The A area is disposed in the display area AA. The second area SA in which the camera or sensor is disposed may be locally disposed within the display area AA and may include at least one second area. In addition, the first area BA may surround the at least one second area SA.

More specifically, the first area BA includes, as units, a plurality of first pixels P1, each including sub-pixels SP1, SP2 and SP3 emitting different colors, and the first pixels P1 are uniformly disposed without spacing from each other.

The second area SA includes, as units, a plurality of second pixels P2, each including sub-pixels SP1, SP2 and SP3 emitting different colors, and a part of the second area SA includes the second pixels P2 densely disposed and the remaining part of the second area SA is left empty and thus functions as a light transmitting portion TA.

Each of the first and second pixels P1 and P2 of the first and second areas BA and SA may include the transistors and light emitting elements ED described with reference to FIG. 2 in each of the sub-pixels SP1, SP2 and SP3.

The second pixel P2 is provided with a light transmitting portion TA in the second area SA and has a second resolution lower than the first resolution of the first pixel P1.

Here, since the second area SA is provided with the second pixel P2 with a lower resolution than the first pixel P1 of the first area BA, and the area occupied by the light transmitting portion TA in the second area SA is not provided with a transistor, the transistor disposition density per area is lower than that of the first area BA. Therefore, in order to have the same light emitting characteristics as the first area BA, the transistors of the second area SA have relatively higher sensitivity than the transistors of the first area BA. For example, the mobility of the transistors of the second area SA is higher than the mobility of the transistors of the first area BA. In addition, in order to have a difference in mobility, for example, the materials of the semiconductor layers of the transistors of the first area BA and the second area SA may be different, or the structures of the transistors may be different.

Meanwhile, among the plurality of transistors provided in each sub-pixel of the first and second areas BA and SA, different mobility characteristics, different sensing sensitivities, or characteristics capable of grayscale expression may be required. For example, switching transistors may have higher mobility than driving transistors for grayscale expression in that high response speed is required.

As shown in FIG. 3, a light emitting display device according to an example of the present disclosure includes a substrate 100 having a first area BA and a second area SA, a plurality of first light emitting portions EM1 provided in the first area BA, a second light emitting portion EM2 and a light transmitting portion TA provided in the second area SA and spaced apart from each other, and a pixel-defining film BNK1 surrounding the first light emitting portions EM1 and a pixel-defining film BNK2 surrounding the second light emitting portions EM2. The pixel-defining film BNK1 may include a light shielding pixel-defining film 240A and a transparent pixel-defining film 250. The pixel-defining film BNK2 may include a light shielding pixel-defining film 240B and a transparent pixel-defining film 250.

In addition, since the light transmitting portion TA of the second area SA is not equipped with transistors, light from the upper part of the substrate 110 may pass through to the lower side of the substrate 110, or light may be transmitted to the upper part of the substrate 110 from the sensor or camera located on the lower side of the substrate 110.

A component for reflecting or shielding light, among the components of the light emitting element ED, may be omitted from the light transmitting portion TA. For example, when the light emitting element ED includes an anode, an intermediate layer, and a cathode, and the anode or the cathode is a reflective electrode, the reflective electrode may be removed from the light transmitting portion TA. In some cases, a part of the intermediate layer may be removed from the light transmitting portion TA to increase the transmittance of the light transmitting portion TA.

Each of the sub-pixels SP1, SP2 and SP3 of the first and second areas BA and SA may include a pixel-defining film BNK1 and BNK2 defining a light emitting portion EM1 or EM2 through which light is transmitted from the light emitting element ED. The pixel-defining film BNSP may include bank and spacer structures, and the pixel-defining film BNSP may surround the light emitting portions EM1 and EM2 and open the light emitting portions EM1 and EM2. The pixel-defining film BNSP may have a matrix shape. The pixel-defining film BNSP may be removed from an area corresponding to the light transmitting portion TA.

Among the components on the substrate 110, the light transmitting portion TA may further include transparent

insulating films.

Meanwhile, the sub-pixels SP1, SP2 and SP3 of the first and second areas BA and SA may further include, as shown in FIG. 2, transistors T1 and T2, and capacitors Cst, as well as switching transistors, EM transistors, and sampling transistors driven by scan signals and EM signals (emission control signals) applied from additional gate lines. The active layers of the transistors included in the sub-pixels provided in the second area SA, rather than those provided in the first area BA, may include oxide semiconductors, polysilicon, amorphous silicon, or the like. The active layers of the switching transistors, EM transistors, and sampling transistors having different characteristics may be formed of the same or different materials. In addition, the switching transistors, EM transistors, and sampling transistors having different characteristics may be configured to have the same or different mobility of each active layer, as necessary.

The second area SA includes a light transmitting portion TA, and the light transmitting portion TA does not have transistors including a metal for transmittance. Therefore, the transistors P2_T of the second area SA are disposed only in the sub-pixels SP1, SP2, and SP3 of the second pixel P2 that are disposed in a limited manner. The second area SA operates the light emitting element only using the transistors disposed in the sub-pixels SP1, SP2, and SP3 of the second pixel P2, and the light emitting intensity of the area corresponding to the second area SA including the light transmitting portion TA must be adjusted. In order to prevent the brightness in the second area SA from decreasing and to impart the same brightness to the first area BA and the second area SA, the driving current intensity required for the transistor located in the second area SA may be greater than the driving current intensity required for the transistor located in the first area BA.

For example, when the disposition density of transistors in the second area SA is 40% of the disposition density of transistors in the first area BA, the transistor in the second area SA requires a current intensity that is more than twice that of the transistor in the first area SA.

The light emitting display device according to the examples of the present disclosure described below has a structure in which a light shielding pixel-defining film is provided around a light emitting portion to prevent internal light generated from the light emitting portion from affecting lower transistors, and a structure in which light emitting efficiency is increased in the second area SA including a sensor or a camera.

For example, the light emitting display devices below in which SP1 in FIG. 3 is a light emitting element that emits blue light, SP2 is a light emitting element that emits green light, and SP3 is a light emitting element that emits red light will be described.

As shown in FIGS. 3 and 4, a light emitting display device 1000A according to a first example of the present disclosure includes a substrate 110 including a first area BA and a second area SA, and light shielding pixel-defining films 240A and 240B of different heights in the first area BA and the second area SA.

That is, the first light shielding pixel-defining film 240A provided in the first area BA exposes the first blue light emitting portion BEM1, the first green light emitting portion GEM1, and the first red light emitting portion REM1, but has a first height H1.

The second light shielding pixel-defining film 240B provided in the second area SA exposes the second blue light emitting portion BEM2, the second green light emitting portion GEM2, the second red light emitting portion REM2, and the light transmitting portion TA, and includes an area having a second height H2 and/or a third height H3 smaller than the first height H1.

A light emitting element ED is included on each of the first blue light emitting portion BEM1, the first green light emitting portion GEM1, the first red light emitting portion REM1, the second blue light emitting portion BEM2, the second green light emitting portion GEM2, and the second red light emitting portion REM2, and light emission of the corresponding sub-pixel occurs.

The light emitting element ED includes a first electrode 210, an intermediate layer 220, and a second electrode 230. The light shielding pixel-defining films 240A and 240B in the first and second areas BA and SA may be disposed on the first electrode 210 and at least partially overlap with the first electrode 210 respectively. The intermediate layer 220 and the second electrode 230 may be disposed over the first electrode 210 which is exposed from the light shielding pixel-defining films 240A and 240B. Also, the intermediate layer 220 and the second electrode 230 may be disposed at least partially disposed over the light shielding pixel-defining films 240A and 240B.

One of the first electrode 210 and the second electrode 230 may include a reflective electrode, and the other may include a transparent electrode or a reflective-transmissive electrode.

When the first electrode 210 includes a reflective electrode, the first electrode 210 may function to shield light from being incident on the transistors therebelow. The first electrode 210 may have a multilayer structure, such as, for example, a laminated structure (Ti/Al/Ti) of aluminum (Al) and titanium (Ti), a laminated structure (ITO/Al/ITO) of aluminum (Al) and ITO, an APC (Ag/Pd/Cu) alloy, a laminated structure of an APC alloy and ITO (ITO/APC/ITO), or a laminated structure (Ag/MoTI) of silver (Ag) and molybdenum/titanium alloy, or may include a single layer structure containing one material selected from silver (Ag), aluminum (Al), molybdenum (Mo), gold (Au), magnesium (Mg), calcium (Ca), or barium BA, or an alloy of two or more materials. For example, the first electrode 210 may have a laminated structure of a first transparent electrode, a reflective electrode, and a second transparent electrode. The second transparent electrode,

which is the uppermost electrode of the first electrode 210, may lower the barrier for hole injection at the interface with the dielectric intermediate layer EL. Here, the first and second transparent electrodes include transparent oxide electrodes such as ITO and IZO.

The first electrode 210 may function as an anode.

The sub-pixels P1_SP of the first area are disposed closely without a light transmitting portion, so that when light is emitted from the first blue light emitting portion BEM1, the first green light emitting portion GEM1, and the first red light emitting portion REM1, the first electrode 210 may prevent light from travelling downward at a right angle, but light reflected diagonally and directed to adjacent sub-pixels on the side may affect the lower transistors. Therefore, the periphery of the first blue light emitting portion BEM1, the first green light emitting portion GEM1, and the first red light emitting portion REM1 in the sub-pixel P1_SP of the first area is provided with a first light shielding pixel-defining film 240A having a first high height H1, to effectively prevent light generated from the light emitting element ED and from being transmitted diagonally to adjacent sub-pixels around the light emitting portion of each sub-pixel.

The transistor of each sub-pixel may include an active layer 151, a gate electrode 161 overlapping the active layer 151, and a first source-drain electrode 171 and a second source-drain electrode 172 connected to both sides of the active layer 151. FIG. 4 shows a sub-pixel P1_SP of the first area, a blue sub-pixel P2_SP1 emitting blue light of the second area, and a green or red sub-pixel P2_SP2 or SP3 emitting green or red light of the second area together, and thus shows only one transistor for each sub-pixel. Each sub-pixel may include a plurality of transistors and the transistors are utilized in different applications and may be formed in different layer structures. In addition, FIG. 4 shows a driving transistor as an example. The switching transistor and the EM transistor may have different structures.

The active layer 151 may include, for example, any one of an oxide semiconductor, crystalline silicon, or amorphous silicon.

When the active layer 151 is formed of an oxide semiconductor, the crystallization process may be omitted, which has advantages of reducing greenhouse gases and improving yield.

When the active layer 151 is formed of an oxide semiconductor, the mobility of the active layer 151 and the transistor may be adjusted by adjusting the metal that combines with oxygen or the ratio of the metal component.

The light generated in the intermediate layer 220 of the light emitting element ED is emitted radially. Among these, the light emitted in the vertical direction is reflected repeatedly between the first electrode 210 and the second electrode 230 and finally comes out to the second electrode 230 and may be used for the light emitting efficiency of the light emitting element ED. Among the light generated in the intermediate layer 220, light directed in a diagonal direction other than a vertical direction may be transmitted to the sub-pixel adjacent to the sub-pixel where the light is emitted through reflection and re-reflection by various reflective means included in the light emitting display device, and when the transmitted light is incident on the transistor located below the light emitting element ED of the adjacent sub-pixel, photocurrent is generated from the transistors and thus the characteristics of the transistors are affected.

For example, the active layer may be used as an oxide semiconductor.

In addition, the active layer of a transistor that requires high-speed operation among the transistors may include an oxide semiconductor having high mobility. The band gap of the oxide semiconductor narrows when the mobility increases. When the oxide semiconductor has a high mobility of about 15 $cm^2/Vs$ to 50 $cm^2/Vs$, the band gap of the oxide semiconductor is approximately 2.8 eV. The active layer having such a narrow band gap may exhibit conductive characteristics even due to short-wavelength light of almost blue light. Therefore, when the active layer having a such a narrow band gap is used in a transistor, the threshold voltage greatly shifts to a negative value.

This is obtained from the relationship between the energy band gap and wavelength in the following Equation 1.

[Equation 1] $\lambda$ [nm] = hc/Eg (wherein $\lambda$ is a wavelength, h is Planck's constant, c is the speed of light, and Eg is the energy band gap) [Equation 1]

In accordance with Equation 1, for example, even blue light having a peak emission wavelength of 440 nm may generate photocurrent in an active layer having an energy band gap of 2.8 eV. This means that, when light generated from a light emitting element ED has a short blue wavelength and is transmitted to an adjacent sub-pixel on the side, the threshold voltage of a transistor located below shifts to a negative value, increasing the off-current of the transistor.

In accordance with Equation 1, the energy band gap and wavelength are inversely proportional to each other.

This means that, when light irradiated to the active layer has a wavelength longer than green light, the effect of causing a change in the characteristics of the active layer is small.

Meanwhile, in the light emitting display device according to the examples of the present disclosure, the sub-pixels SP of the first area are close to a first blue light emitting portion BEM1, a first green light emitting portion GEM1, and a first red light emitting portion REM1 without a light transmitting portion. In this case, the blue light emitting portion emits short-wavelength light having, for example, an emission peak of 440 nm and the short-wavelength light changes the characteristics of the oxide semiconductor layer with high mobility. When light is radiated from the first blue light emitting

portion BEM1, it may be directed to sub-pixels in the horizontal, vertical, and diagonal directions, so that the first area BA has a first light shielding pixel-defining film 240A having a high first height H1 in all sub-pixels P1_SP, it is possible to prevent light emitted from the first blue light emitting portion BEM1 from being transmitted to adjacent sub-pixels regardless of which direction it is directed in among the horizontal, vertical, and diagonal directions.

The disposition density of sub-pixels in the second area SA including the sensor or camera is lower than that in the first area BA. Accordingly, the second blue light emitting portion BEM2, the second green light emitting portion GEM2, and the second red light emitting portion REM2 are each adjacent to other light emitting portions, but some thereof are adjacent to the light transmitting portion TA. A high current is applied to the second area SA to impart brightness equivalent to that of the first area BA to the sub-pixel having a low disposition density. In addition, for this purpose, the mobility of the active layer used for the transistors of the second area SA may be formed relatively higher than that of the active layer of the transistors of the first area BA in response to high-current, high-brightness driving.

Meanwhile, in the second area SA, the second light shielding pixel-defining film 240B may include a first height portion 240BA exposing the second blue light emitting portion BEM2, a second height portion 240BB exposing the second green light emitting portion GEM2 and the second red light emitting portion REM2, and a third height portion 230BC. The first height portion 240BA has the first height H1, the second height portion 240BB has a second height H2 smaller than the first height H1 and the third height portion 240BC has a third height H3 smaller than the second height H2. Since the second light shielding pixel-defining film 240B having the first to third height portions 240BA, 240BB, and 240BC, the second light shielding pixel-defining film 240B is distinguished from the first light shielding pixel-defining film 240A provided in the first area BA.

As described above, when the mobility of the active layer formed of an oxide semiconductor is high, the energy band gap is small. In order to prevent the influence of the characteristics of the lower transistor when the light coming from the second blue light emitting portion BEM2 of the second area SA is directed to an adjacent sub-pixel, the periphery of the second blue light shielding pixel-defining film 240BA of the second area SA is designed to have a high first height H1. In addition, the second green light emitting portion GEM2 and the second red light emitting portion REM2 that are not adjacent to the second blue light emitting portion BEM2 are provided with a second light shielding pixel-defining film 240BB having a relatively low second height H2. This is because, even if green light or red light is generated, it has little influence on the change in the characteristics of the transistor of the adjacent sub-pixel.

In addition, the second area SA is provided with a light transmitting portion TA in addition to the second blue, green, and red light emitting areas BEM2, GEM2, and REM2, and a second light shielding pixel-defining film 240BC having a third height H3 smaller than the second height H2 is provided in an area adjacent to the light transmitting portion TA to increase the aperture ratio of the light transmitting portion TA and increase the light sensitivity of the sensor or camera.

Meanwhile, the first and second light shielding pixel-defining films 240A and 240B may include an opaque material containing at least one of a color pigment, organic black, or carbon to prevent optical interference between adjacent sub-pixels SP. In some cases, the first and second light shielding pixel-defining films 240A and 240B may include a black pigment in polyacrylic, polyimide, or polyamide.

Meanwhile, the first and second light shielding pixel-defining films 240A and 240B around the first blue light emitting portion BEM1, the first green light emitting portion GEM1, the first red light emitting portion REM1, the second blue light emitting portion BEM2, the second green light emitting portion GEM2, and the second red light emitting portion REM2 may be partially removed at a portion where the light emitting element ED and the transistor T2 are connected. The light emitting element ED and the transistor T2 may be, for example, directly connected between the first source/drain electrode 171 and the first electrode 210 of the light emitting element ED, or may be connected by further providing a connection electrode 181 between the first source/drain electrode 171 and the first electrode 210 as shown in the drawing. In any case, since the light transmitted to the side is blocked in the area where the first source drain electrode 171 and the connection electrode 181 are disposed, the light shielding pixel-defining film may be omitted in this area.

A transparent pixel-defining film 250 may be further provided on the first and second light shielding pixel-defining films 240A and 240B provided in the first area BA and the second area SA. The transparent pixel-defining film 250 may define a light emitting portion around each light emitting portion and protect the first and second light shielding pixel-defining films 240A and 240B. The transparent pixel-defining film 250 may be provided under the intermediate layer 220 and the second electrode 230.

The transparent pixel-defining film 250 may include an inorganic material or an organic material. The transparent pixel-defining film 250 may include, for example, polyacrylic, polyimide, polyamide, silicon oxide, silicon nitride, or the like.

In the light emitting display device according to one example of the present disclosure, the light emitting element ED may increase the surface area of each light emitting element compared to the first area BA in order to improve the light emitting efficiency of the second area SA. For this purpose, the light emitting element ED of the second area SA may have a groove 131R on the upper surface of the second planarization film 131 to increase the surface area of the first electrode 210A including the reflective electrode of the light emitting element ED, and improve the reflection efficiency and light emitting efficiency.

Since the second area SA must be capable of displaying colors in the second area SA through sub-pixels having

lower resolution and lower disposition density than the first area BA, all of the second blue light emitting portion BEM2, the second green light emitting portion GEM2, and the second red light emitting portion GEM2 have a groove 131R. The light emitting element ED of the second area SA may be disposed in the groove 131R. The first electrode 210A which is disposed on the groove 131R and exposed from the second light shielding pixel-defining film 240B in the second area SA has a wider surface area than the first electrode 210 which is exposed from the first light shielding pixel-defining film 240A in the first area BA.

Therefore, the surface area of the second blue light emitting portion BEM2, the second green light emitting portion GEM2, and the second red light emitting portion GEM2 disposed on the groove 131R may be wider than the surface area of the first blue light emitting portion BEM1, the first green light emitting portion GEM1, and the first red light emitting portion REM1 on the second planarization film 131.

In the light emitting display device according to one example of the present disclosure, the groove 131R may not overlap the second light shielding pixel-defining film 240B. Accordingly, the effects of increased reflection efficiency and increased luminous efficiency obtained by the structure of the groove 131R are not limited by the second light shielding pixel-defining film 240B.

In the light emitting display device according to one example of the present disclosure, the groove 131R may be provided in each of the light emitting portions BEM2, GEM2, and REM2 of the second area SA, such that the surface area of the second blue light emitting portion BEM2 may be larger than the surface area of the first blue light emitting portion BEM1, the surface area of the second green light emitting portion GEM2 may be larger than the surface area of the first green light emitting portion GEM1, and the surface area of the second red light emitting portion REM2 may be larger than the surface area of the first red light emitting portion REM1.

The intermediate layer 220 of the light emitting element ED may include a hole injection layer, a hole transport layer, a light emitting layer, an electron transport layer, and an electron injection layer. The intermediate layer 220 may be formed by a plurality of stacks including a hole transport layer, a light emitting layer, and an electron transport layer, and may be formed in a tandem structure including a charge generation layer between the stacks. The charge generation layer may include, for example, an n-type charge generation layer and a p-type charge generation layer.

The light emitting layers included in the intermediate layer 220 may be different for respective sub-pixels. For example, a blue light emitting layer may be included in at least the blue light emitting portions BEM1 and BEM2 of the first area and the second area, a green light emitting layer may be included in at least the green light emitting portions GEM1 and GEM2 of the first area and the second area, and a red light emitting layer may be included in at least the red light emitting portions REM1 and REM2 of the first area and the second area. The red light emitting layer, the green light emitting layer, and the blue light emitting layer may be disposed for each sub-pixel SP on each first electrode 210.

The intermediate layer 220 may include, excluding the light emitting layer, the hole injection layer, the hole transport layer, the electron transport layer, and the electron injection layer, which may be continuously disposed not only in each sub-pixel P1_SP SP1, SP2 or SP3 of the first area and each sub-pixel P2_SP1, P2_SP2, or P2_SP3 of the second area, but also in the light-transmitting portion TA, but is not necessarily limited thereto.

As another example, at least two or more light emitting layers among a red light emitting layer, a green light emitting layer, and a blue light emitting layer may be stacked and disposed in each sub-pixel SP, and white may be displayed through the light emitting element ED. In this case, the light emitting color of each sub-pixel may further include a color filter on top of the light emitting element ED to express the corresponding color.

As described above, the intermediate layer 220 may be disposed in a tandem structure of two or more stacks STACK. At this time, each light emitting element ED may include a charge generation layer disposed between the stacks. The charge generation layer may be a common layer disposed over the entire surface of the display area AA. When light emitting layers of different colors are provided in each light emitting portion, the same light emitting layers may be disposed in a multi-stacked structure including the charge generation layer between the light emitting portions.

The second electrode 230 may be formed by thinning a transparent electrode such as ITO or IZO, or a reflective transparent electrode such as silver, a silver alloy, magnesium, a magnesium alloy, ytterbium (Yb), or an ytterbium alloy. In another example, in order to increase the transmittance in the light transmitting portion TA, the second electrode 230 may be partially removed from the light transmitting portion TA or formed with a small thickness. The second electrode 230 may be a common layer that is disposed in common to the sub-pixels SP and applies the same voltage thereto. For this purpose, the second electrode 230 may be disposed to extend from the display area AA to a part of the non-display area NA.

The second electrode 230 may be a light transmitting electrode. The second electrode 230 may include a transparent conductive metal material (TCO) such as ITO or IZO that can transmit light, or a semi-transmissive metal material such as magnesium (Mg), silver (Ag), or an alloy of magnesium (Mg) and silver (Ag). When the second electrode 230 is disposed as a semi-transmissive metal material, the light emission efficiency may be increased by the microcavity effect.

A capping layer (not shown) is further formed on the second electrode 230 to protect the second electrode 230 of the light emitting element ED and increase the light emission efficiency upward.

An encapsulation layer 300 is disposed on the light emitting element ED. The encapsulation layer 300 may cover

the display area AA and the non-display area NA to prevent oxygen or moisture from penetrating into the light emitting element ED. If necessary, other layers such as a capping layer may be interposed between the encapsulation layer 300 and the second electrode 230.

The encapsulation layer 300 may include a plurality of layers. The encapsulation layer 300 may have a structure in which an inorganic film including an inorganic insulating material and an organic film including an organic insulating material are alternately laminated. For example, the inorganic insulating material may include one or more materials such as silicon oxide, silicon nitride, and/or silicon oxynitride.

The organic insulating material may include one or more materials selected from the group consisting of polyethylene terephthalate, polyethylene naphthalate, polycarbonate, polyimide, polyethylene sulfonate, polyoxymethylene, polyarylate, and hexamethyldisiloxane.

The configuration of the lower side of the light emitting element ED will be described with reference to FIGS. 4 and 5.

FIG. 5 shows two transistors provided at the lower side of the light emitting element ED. The first transistor T1 may be the switching transistor of FIG. 2 and the second transistor T2 may be a driving transistor.

FIG. 4 shows a driving transistor at each of the subpixel P1_SP of the first area BA and the sub-pixels P2_SP1, P2_SP2, and P2_SP3 of the second area SA. A structure of the switching transistor at each subpixel may be referred by FIG. 5.

The first transistor T1 may include a first light shieldingpattern 141, a first active layer 152 overlapping the first light shielding pattern 141, a first gate electrode 162 partially overlapping the first active layer 152, and a source-drain electrode connected to a side of the first active layer 152. Another source-drain electrode may be connected to another side of the first active layer 152.

The second transistor T2 may include a second light shielding pattern 145, a second active layer 151 overlapping the second light shielding pattern 145, a second gate electrode 161 partially overlapping the second active layer 151, and source-drain electrodes 171 and 172 connected to both sides of the second active layer 151.

The first and second light shielding patterns 141 and 145 prevent the first and second active layers 152 and 151 of the first and second transistors T1 and T2 from being affected by a lower light transmitted from a substrate 110. The first and second light shielding patterns 141 and 145 may be disposed at different layers.

The first transistor T1 may include a gate connection electrode 174 to connect the first gate electrode 162 and the first light shielding pattern 141 at a same layer of the source-drain electrode 173. The gate connection electrode 174 may be vertically branched and connected through the fifth and sixth contact holes CT5 and CT6 present in the insulating film. In this case, the first light shielding pattern 141 can function as a bottom gate electrode and the first gate electrode 162 can function as a top gate electrode, thus a high driving of the first transistor T1 can be possible.

One electrode 172 of the source-drain electrodes of the second transistor T2 may be connected to the second active layer 151 and the second light shielding pattern 145. One electrode 172 of the source-drain electrodes of the second transistor T2 may be vertically branched and connected through the second and third contact holes CT2 and CT3 present in the insulating film. The other electrode 171 of the source-drain electrodes 171 of the second transistor T2 may be connected to the other side of the second active layer 151.

The first and second active layers 151 and 152 of the first and second transistors T1 and T2 may be located on the same layer. When the first and second active layers 151 and 152 are disposed on the same layer, the active layers of the respective transistors may be formed in the same process and thus the number of masks may be reduced. The first and second active layers 151 and 152 may include at least one of an oxide semiconductor, crystalline silicon, or amorphous silicon.

When the first and second active layers 151 and 152 are formed of an oxide semiconductor, the crystallization process is omitted, thus having an effect of reducing greenhouse gases.

The first and second transistors T1 and T2 may be connected to one side of the light shielding pattern and the active layer, respectively, thus having the effect of stabilizing the potential of the light shielding pattern. The first transistor T1 may be a switching transistor and the second transistor T2 may be a driving transistor.

The first and second transistors T1 and T2 may be provided in the same sub-pixel. The distances between the light shielding pattern and the active layer of the first and second transistors T1 and T2 are different. When the distance between the light shielding pattern and the active layer decreases, the S-factor increases, which is advantageous in expressing gradation including low gradation. Since the second area has a lower disposition density of the sub-pixels than that of the first area due to the presence of the light transmitting portion, the first transistor T1 corresponding to relatively high current driving may be used as the driving transistor of the second area and the second transistor T2 may be used as the driving transistor of the first area for normal gradation expression. The first and second active layers provided in the first and second transistors T1 and T2 may include different oxide semiconductors to reduce the mobility difference.

The first pixel P1 of the first area BA and the second pixel P2 of the second pixel SA of the second area each include the first to third sub-pixels SP1, SP2, and SP3, and each sub-pixel includes a switching transistor and a driving transistor. In addition, for the purpose of compensation, the sub-pixel may further include a light emitting control transistor

operated by a light emitting control signal, a plurality of switching transistors, or the like.

Compared to the first to third sub-pixels (P1_SP) included in the first area BA, the first to third sub-pixels (P2_SP1, P2_SP2, P2_SP3) in the second area SA require high brightness and high current driving, and therefore the configurations of switching transistors and driving transistors may be different in the first area BA and the second area SA.

The substrate 110 may be formed of a flexible plastic material and may have flexible characteristics. As another example, the substrate 110 may include a thin glass material having flexibility.

For example, the substrate 110 may include first and second organic films overlapping each other with an inorganic interlayer insulating film therebetween. The first and second organic films may include identical or different organic films such as PET (polyethylene terephthalate) and polyimide. In some cases, an adhesive film such as a PSA (pressure sensitive adhesive) film may be included between the first and second organic films.

The substrate 110 functions to support and protect components of the display device 1000 placed thereon.

A plurality of insulating films (200: 121, 122, 123, 124, 125, 126, 127, 128, 129, 130 and 131) is stacked in the display area AA and the non-display area (see NA of FIG. 1) of the substrate 110 so that the electrodes (141, 145, 161/162, 171/172/173, 174) constituting the driving transistor T2 and the switching transistor T1 of the first and second areas may be insulated from each other.

The first buffer layer 121 and the second buffer layer 122 are formed of an inorganic insulating material and are disposed on the display area AA and the non-display area NA of the substrate 110. The first buffer layer 121 and the second buffer layer 122 are disposed on the substrate 110 to protect structures disposed on the substrate 110 from moisture penetrating through the substrate 110 and to flatten the surface of the substrate 110.

The first buffer layer 121 may be disposed up to the edge of the substrate 110 to prevent moisture from penetrating from the edge of the substrate 110. The first buffer layer 121 may include a plurality of inorganic films, including other types of transistors in addition to the transistors disposed on the substrate 110 and may be used as an interlayer insulating film or a gate insulating film of other transistors.

For example, the first buffer layer 121 and the second buffer layer 122 may include one or more inorganic films of a silicon oxide (SiOx) film, a silicon nitride (SiNx) film, and a silicon oxynitride (SiOxNy) film, or may include a multilayer film in which the inorganic films described above are laminated.

A first light shielding pattern 141 may be disposed on the second buffer layer 122 and formed of a conductive metal material. Specifically, the conductive metal material may include at least one of an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti).

A first insulating film 123 and a second insulating film 124 may be sequentially provided on the second buffer layer 122 on which the first light shielding pattern 141 is disposed.

The first and second buffer layers 121 and 122 and the first and second insulating films 123 and 124 may be used as one of a buffer layer, a gate insulating film, or an interlayer insulating film for an active layer formed as a layer different from the active layer 151 or 152 of the illustrated transistor.

In addition, the first and second insulating films 123 and 124 may function as buffer layers for the active layer disposed thereon.

The first and second insulating films 123 and 124 may include an inorganic material. The inorganic material may include, for example, a silicon oxide (SiOx) film, a silicon nitride (SiNx) film, or multiple layers thereof. In some cases, the second buffer layer 113 may be used as a gate insulating film of a transistor including a polysilicon semiconductor layer.

A second light shielding pattern 145 may be disposed on the second insulating film 124 as a conductive metal material. Specifically, the conductive metal material may include at least one of an aluminum-based metal such as aluminum (Al) or an aluminum alloy, a silver-based metal such as silver (Ag) or a silver alloy, a copper-based metal such as copper (Cu) or a copper alloy, a molybdenum -based metal such as molybdenum (Mo) or a molybdenum alloy, chromium (Cr), tantalum (Ta), neodymium (Nd), or titanium (Ti).

For example, the first and second light shielding patterns 141 and 145 may be used as electrodes of a storage capacitor included in a circuit of a sub-pixel. The first and second light shielding patterns 141 and 145 may be a single layer or may have a laminated structure of a plurality of different metal materials.

A third insulating film 125 and a fourth insulating film 126 may be sequentially provided on the second insulating film 124 on which the second light shielding pattern 145 is disposed.

The third insulating film 125 and the fourth insulating film 126 may include an inorganic material. The inorganic material may include, for example, a silicon oxide (SiOx) film or a multilayer film in which inorganic films are laminated.

The fourth insulating film 126 is disposed below each active layer 151 or 152 and may function as a buffer layer. In addition, the fourth insulating film 126 may serve to flatten the surface of the region where the active layer 151 or 152 disposed above is formed.

The first active layer 152 of the first transistor T1 and the second active layer 151 of the second transistor T2 are disposed on the fourth insulating film 1261.

The first and second active layers 152 and 151 are formed in the same process and may include an oxide semiconductor material. The oxide semiconductor material may be formed of a combination of at least one metal selected from zinc (Zn), indium (In), gallium (Ga), tin (Sn), and titanium (Ti), and an oxide. In some cases, the mobility may be increased in the active layer included in the sub-pixels P2_SP1, P2_SP2, and P2_S3 of the second area compared to the sub-pixels of the first area.

Mobility may be increased by further incorporating a metal with high conductivity, such as tin (Sn) or iron (Fe), in the oxide semiconductor material, or the mobility may be adjusted by changing the composition ratio of the metal combined with oxygen.

The light emitting display device according to the examples of the present disclosure includes first and second light shielding pixel-defining films 240A and 240B in the configuration of pixel-defining films BNK1 and BNK2 defining each light emitting portion of a light emitting element ED disposed above the transistors T1 and T2, thereby blocking light transmitted laterally from adjacent sub-pixels, preventing threshold voltage fluctuations of the transistors and improving light sensitivity.

In addition, since the first area BA has a high disposition density of sub-pixels and all sub-pixels are laterally adjacent to a blue light emitting portion, the first light shielding pixel-defining film 240A disposed around the first blue, green, and red light emitting portions BEM1, GEM1, and REM1 has a high first height H1. Since the disposition density of sub-pixels in the second area SA is relatively low and the blue light emitting portion has a greater influence on the active layer formed of oxide semiconductor than the green light emitting portion or the red light emitting portion, the second light shielding pixel-defining film 240BA around the second blue light emitting portion BEM2 is designed to have the first height H1, and the second green light emitting portion GEM2 or the second red light emitting portion REM2 not adjacent to the second blue light emitting portion BEM2 has the second light shielding pixel-defining film 240BB designed to have the lower second height H2. In addition, the height of the second light shielding pixel-defining film 240BC in the area adjacent to the light transmitting portion TA that does not have the transistor is further reduced to the third height H3. The light transmitting portion TA may not have the light shielding pixel-defining film for light transmittance.

A fifth insulating film 127 is disposed on the fourth insulating film 126 provided with the first and second active layers 152 and 151 of the first and second transistors T2 and T1 of each sub-pixel. The fifth insulating film 127 may be used as a gate insulating film. The fifth insulating film 127 may be formed of a silicon oxide film, or the like.

First and second gate electrodes 162 and 161 are disposed on the fifth insulating film 127 such that they partially overlap the first and second active layers 152 and 151, respectively. The gate electrodes 162 and 161 may include at least one of an aluminum-based metal such as aluminum (Al) or an aluminum alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti). The gate electrodes 162 and 161 may include a single layer or multiple layers.

A sixth insulating film 128 and a seventh insulating film 129 are disposed on the fifth insulating film 127 to overlap the first and second gate electrodes 162 and 162. For an example, the sixth insulating film 128 and the seventh insulating film 129 may comprise inorganic material such as a silicon oxide layer, a silicon nitride layer. In some cases, at least one of the sixth insulating film 128 and the seventh insulating film 129 may comprise multiple layers in which inorganic layers are stacked.

The first, second and fourth contact holes CT1, CT2, and CT4 are provided in the fifth to seventh insulating films 127, 128, and 129 to expose both sides of the upper surface of the second active layer 151 and the upper surface of the first active layer 152. In addition, the third contact hole CT3 is provided in the third to seventh insulating films 125, 126, 127, 128, and 129 to expose a part of the upper surface of the second light shielding pattern 145. An upper surface of the first light shielding pattern 141 is exposed through the sixth contact hole CT6 in the first to seventh insulating films 123, 124, 125, 126, 127, 128, and 129, and a part of the upper surface of the first gate electrode 162 is exposed through the fifth contact hole CT5 in the sixth and seventh insulating films 128 and 129.

By conductive metal material, the first source-drain electrode 171 and the second source-drain electrode 172 is filled with the first, second, and third contact holes CT1, CT2, and CT3. As shown in FIG. 5, the second source-drain electrode 172 is provided to overlap with the second and third contact holes CT2 and CT3 and can together connect one side of the upper surface of the second active layer 151 of the second transistor T2 and an upper surface of the second light shielding pattern 145.

The conductive metal material is filled in the fourth, fifth and sixth contact holes CT4, CT5, and CT6 and then the third source-drain electrode 173 and the fourth source-drain electrode (not shown), and a gate connection electrode 174 are provided. The third source-drain electrode 173 and the fourth source-drain are connected to both sides of the upper surface of the first active layer 152. The gate connection electrode 174 overlaps with the first gate electrode 162 and the first light shielding pattern 141, respectively, and is connected to the first gate electrode 162 and the first light shielding pattern 141 through the fifth and sixth contact holes CT5 and CT6.

The first light shielding pattern 141 and the first gate electrode 162 are connected through the gate connection electrode 174 and thus have the same potential. Therefore, the first light shielding pattern 141 and the first gate electrode 162 may be used as gates on and under the first active layer 152, respectively. Therefore, the first transistor T1 includes a

dual gate and thus has a high-speed driving characteristic, and has a dual switching function and thus is easily disposed at a high density in a limited area.

The conductive metal material constituting each of the source/drain electrodes 171, 172 and 173 and the gate connection electrode 174 may include at least one of an aluminum-based metal such as aluminum (Al) or an aluminum alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti).

A first planarization film 130 covering the source-drain electrodes 171, 172 and 173 and the gate connection electrode 174 may be provided. In addition, a seventh contact hole CT7 exposing the upper portion of the first source-drain electrode 171 is formed in the first planarization film 130.

The first planarization film 130 may be formed of an inorganic insulating material or an organic insulating material. The inorganic insulating material may constitute, for example, a silicon oxide (SiOx) film, a silicon nitride (SiNx) film, or a multilayer film in which inorganic films are laminated. The organic insulating material may include one or more materials selected from an acrylic resin, a phenolic resin, a polyimide resin, an unsaturated polyester resin, a polyamide resin, benzocyclobutene, a polyphenylene resin, and a polyphenylene sulfide resin.

A connection electrode 181 may be provided such that it fills the contact hole of the first planarization film 130 and may be connected to the first source/drain electrode 171 of the second transistors T2 through a conductive metal material. The conductive metal material may include at least one of an aluminum-based metal such as aluminum (Al) or an aluminum alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti).

A second planarization film 131 is disposed on the first planarization film 130 on which the connection electrode 181 is disposed, and includes an eighth contact hole CT8 to expose an upper surface of the connection electrode 181 in the second planarization film 131. In addition, in the sub-pixels P2_SP1, P2_SP2, and P2_SP3 of the second area, the second planarization film 131 is provided with a groove 131R in which a component of the second planarization film 131 is removed to a predetermined depth from the upper surface of the second planarization film 131.

The second planarization film 131 may be formed of an organic insulating material to planarize the surface on which the light emitting element ED is formed. The organic insulating material may include at least one material selected from an acrylic resin, a phenolic resin, a polyimide resin, an unsaturated polyester resin, a polyamide resin, benzocyclobutene, a polyphenylene resin, and a polyphenylene sulfide resin.

The first electrode 210 of the light emitting element ED may be connected to the connection electrode 181 through the eighth contact hole CT8 of the second planarization film 131.

Examples of the present disclosure provide a light emitting display device that exhibits improved brightness based on structural change in an area where light emitting portions and light transmitting portions are mixed.

The light emitting display device according to examples of the present disclosure is capable of preventing the effects of upper light and internally scattered light on the lower components based on the light shielding pixel-defining film disposed around the light emitting portion.

The light emitting display device according to examples of the present disclosure includes a light shielding pixel-defining film in a structure including an active layer of a high-mobility oxide semiconductor and includes a light shielding pixel-defining film having a low height in the area where the sensor or camera is disposed, thereby increasing the light transmittance of the area where the sensor and camera are disposed.

The light emitting display device according to examples of the present disclosure reduces the difference in height between the light shielding pixel-defining film around a blue light emitting portion and a green or red light emitting portion in the area where a sensor or a camera is disposed, thereby preventing great changes in the characteristics of a high-mobility oxide semiconductor when irradiated with relatively short-wavelength light.

The light emitting display device according to examples of the present disclosure is capable of preventing light generated from an adjacent light emitting element from being transmitted to a light transmitting portion based on the light shielding pixel-defining film disposed around the light transmitting portion.

The light emitting display device according to examples of the present disclosure is capable of preventing a rapid change in brightness through a gradual thickness change of a light shielding pixel-defining film at the boundary between a light emitting portion and a light transmitting portion.

The light emitting display device according to the examples of the present disclosure is capable of responding to the high brightness characteristics required for the sensor unit because the transistors in the sensor unit have high mobility characteristics.

The light emitting display device according to the examples of the present disclosure includes a groove in the light emitting portions of the area where the sensor or the camera is disposed, thereby improving both reflection efficiency and luminous efficacy. Therefore, the light emitting display device has sustainable significance, thus realizing ESG (environmental/social/governance) goals.

The light emitting display device according to the examples of the present disclosure has a light shielding pixel-defining film, thereby preventing changes in a transistor caused by light generated from a light emitting element and

reducing a defect rate of the transistor. The light emitting display device according to the examples of the present disclosure can reduce the amount of materials used throughout the manufacturing process, such as gases and etchants for manufacturing the display device because active patterns of different structures can be manufactured in the same process. Accordingly, it is possible to provide a light emitting display device capable of process optimization and reducing greenhouse gases generated due to the manufacturing process. In addition, the light emitting display device according to the examples of the present disclosure forms active layers for each area in the same process, thereby reducing processes required for additional materials, reducing production energy, and reducing greenhouse gases that may be generated through the manufacturing process through process optimization. Accordingly, it is possible to obtain the ESG (environmental/social/governance) effects through process optimization.

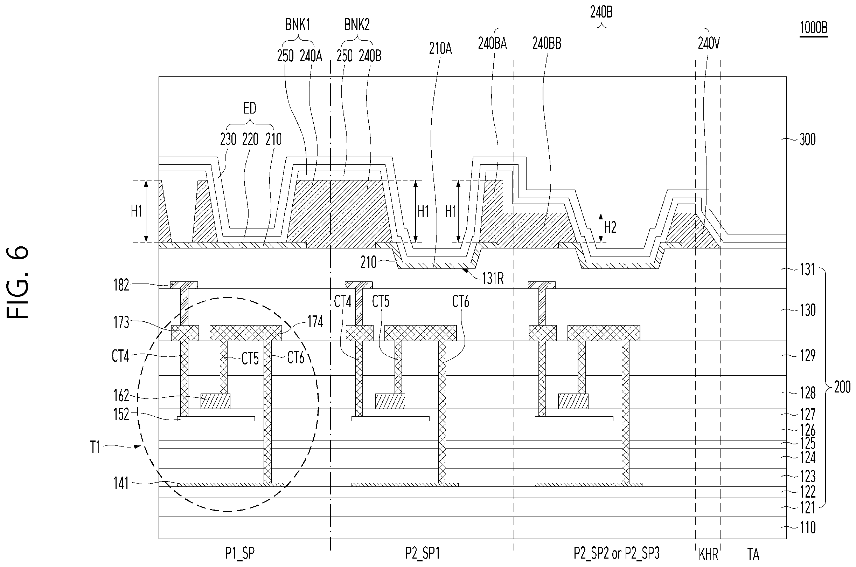

FIG. 6 is a cross-sectional view illustrating a light emitting display device according to the second example of the present disclosure.

As shown in FIG. 6, in the light emitting display device 1000B according to the second example of the present disclosure, the second light shielding pixel-defining film 240B in the second area SA including the sensor or the camera. The second light shielding pixel-defining film 240B may have a first height portion 240BA having a first height H1 for the second blue light emitting portion BEM2 and a second height portion 240BB having a second height H2 lower than the first height H1 for the second green light emitting portion GEM2 and the second red light emitting portion REM2. The second light shielding pixel-defining film 240B may further include a variation portion 240V having a thickness change portion that gradually decreases from the second height H2 at the boundary portion KHR between the light transmitting portion TA and the second green or red light emitting portion GEM2 or REM2.

In the light emitting display device according to the second example of the present disclosure, the variation portion 240V of the second light shielding pixel-defining film 240B may have a lower height with a decreasing distance from the light transmitting portion TA.

As such, the height of the variation portion 240V of the second light shielding pixel-defining film 240B gradually changes at the boundary between the light transmitting portion TA and the adjacent sub-pixel P2_SP2 or P2_SP3 to prevent a great change in brightness between the light transmitting portion TA and the adjacent sub-pixel P2_SP. The variation portion 240V of the second light shielding pixel-defining film 240B whose height gradually changes can prevent the boundary between the light emitting portion REM2, GEM2, or BEM2, and the light transmitting portion TA from being seen in the second area.

FIG. 6 shows a switching transistor at each of the subpixel P1_SP of the first area BA and the sub-pixels P2_SP1, P2_SP2, and P2_SP3 of the second area SA.

Meanwhile, the second example has the same effects with the same configuration as in the first example. The description of the same parts is omitted.

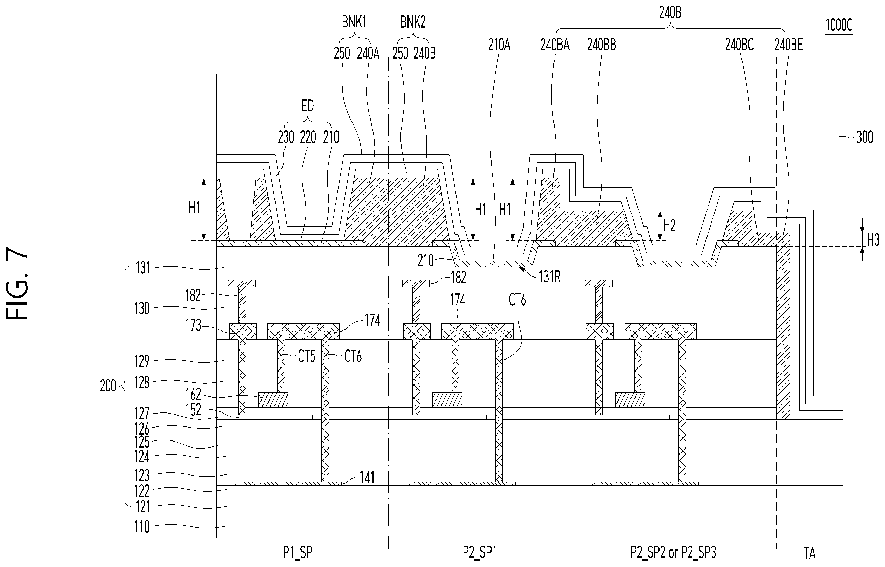

FIG. 7 is a cross-sectional view illustrating a light emitting display device according to the third example of the present disclosure.

As shown in FIG. 7, the light emitting display device according to the third example of the present disclosure may include a plurality of inorganic insulating films 121, 122, 123, 124, 125, 126, 127, 128, and 129, and first and second planarization films 130 and 131 between the substrate 110 and the light emitting element ED.

In addition, at least one of the plurality of inorganic insulating films 121, 122, 123, 124, 125, 126, 127, 128, and 129, and the first and second planarization films 130, and 131 around the light transmitting portion TA may have a side wall. In the light transmitting portion TA, at least one of the plurality of inorganic insulating films 121, 122, 123, 124, 125, 126, 127, 128, and 129, and the first and second planarization films 130 and 131 may be removed to increase the transmittance of the light transmitting portion.

A light emitting display device 1000C according to the third example of the present disclosure includes a substrate 110 including a first area BA and a second area SA, and the first light shielding pixel-defining films 240A in the first area BA and the second light shielding pixel-defining films 240B in the second area SA having different structures.

That is, the first light shielding pixel-defining film 240A provided in the first area BA exposes the first blue light emitting portion BEM1, the first green light emitting portion GEM1, and the first red light emitting portion REM1, and has a first height H1.

The second light shielding pixel-defining film 240B provided in the second area SA includes a first height portion 240BA exposing the second blue light emitting portion BEM2, a second height portion 240BB exposing the second green light emitting portion GEM2 and the second red light emitting portion REM2, and a third height portion 230BC adjacent to light transmitting portion TA. The first height portion 240BA has the first height H1 and the second height portion 240BB has a second height H2 smaller than the first height H1 and the third height portion 240BC has a third height H3 smaller than the second height H2.

A height of the second light shielding pixel-defining film 240B in the region surrounding the light emitting portions BEM2, GEM2, and REM2 adjacent to the light transmitting portion TA may be further lowered to the third height H3. In addition, the transparent pixel-defining film 250 may also be removed from the light transmitting portion TA to increase the light transmittance of the light transmitting portion TA.

In the light emitting display device 1000C according to the third example of the present disclosure, a light shielding pixel-defining film 240BE may be included on the side wall of at least one of the plurality of inorganic insulating films 121, 122, 123, 124, 125, 126, 127, 128, and 129, and the first and second planarization films 130 and 131. In this case, internally scattered light guided laterally between the light transmitting portion TA and the adjacent sub-pixels P2_SP1, P2_SP2, and P2_SP3 may be completely blocked around the light transmitting portion TA, thereby improving the light sensitivity in the light transmitting portion TA. The light shielding pixel-defining film 240BE may be connected to the second shielding pixel-defining film 240B. The light shielding pixel-defining film 240BE may be integral with the second shielding pixel-defining film 240B.

In addition, the light emitting display device 1000C according to the third example of the present disclosure can completely block the influence of internally scattered light transmitted from the light transmitting portion TA to the surrounding light emitting portions REM2, GEM2, and BEM2, and can effectively block transmission of the internally scattered light to the transistor.

The light shielding pixel-defining film 240BE provided on the sidewall of at least one of the plurality of inorganic insulating films 121, 122, 123, 124, 125, 126, 127, 128, and 129, and the first and second planarization films 130 and 131 has a thickness equivalent to the third height H3 around the adjacent light emitting portions BEM2, GEM2, and REM2, and thus avoids a decrease in the transmittance of the light transmitting portion TA.

Examples of the present disclosure provide a light emitting display device that exhibits improved brightness based on structural change in an area where light emitting portions and light transmitting portions are mixed.

The light emitting display device according to examples of the present disclosure is capable of preventing the effects of upper light and internally scattered light on the lower components based on the light shielding pixel-defining film disposed around the light emitting portion.

The light emitting display device according to examples of the present disclosure includes a light shielding pixel-defining film in a structure including an active layer of a high-mobility oxide semiconductor and includes a light shielding pixel-defining film having a low height in the area where the sensor or camera is disposed, thereby increasing the light transmittance of the area where the sensor and camera are disposed.

The light emitting display device according to examples of the present disclosure reduces the difference in height between the light shielding pixel-defining film around a blue light emitting portion and a green or red light emitting portion in the area where a sensor or a camera is disposed, thereby preventing great changes in the characteristics of a high-mobility oxide semiconductor when irradiated with relatively short-wavelength light.

The light emitting display device according to examples of the present disclosure is capable of preventing light generated from an adjacent light emitting element from being transmitted to a light transmitting portion based on the light shielding pixel-defining film disposed around the light transmitting portion.

The light emitting display device according to examples of the present disclosure is capable of preventing a rapid change in brightness through a gradual thickness change of a light shielding pixel-defining film at the boundary between a light emitting portion and a light transmitting portion.

The light emitting display device according to the examples of the present disclosure is capable of responding to the high brightness characteristics required for the sensor unit because the transistors in the sensor unit have high mobility characteristics.

The light emitting display device according to the examples of the present disclosure includes a groove in the light emitting portions of the area where the sensor or the camera is disposed, thereby improving both reflection efficiency and luminous efficacy. Therefore, the light emitting display device has sustainable significance, thus realizing ESG (environmental/social/governance) goals.

A light emitting display device according to one example of the present disclosure may comprise a substrate including a first area and a second area, a first light shielding pixel-defining film provided at the first area, exposing a first blue light emitting portion, a first green light emitting portion, and a first red light emitting portion, and having a first height, a second light shielding pixel-defining film provided at the second area, including a region exposing a second blue light emitting portion, a second green light emitting portion, and a second red light emitting portion and a light transmitting portion, and including an area having a second height smaller than the first height; and a light emitting element on the first blue light emitting portion, the first green light emitting portion, the first red light emitting portion, the second blue light emitting portion, the second green light emitting portion, and the second red light emitting portion.

In a light emitting display device according to one example of the present disclosure, the second light shielding pixel-defining film may have the second height around the second green light emitting portion and the second red light emitting portion.

In a light emitting display device according to one example of the present disclosure, a height of the second light shielding pixel-defining film may decrease with a decreasing distance from the light transmitting portion.

In a light emitting display device according to one example of the present disclosure, the second light shielding pixel-defining film has the second height around the second green light emitting portion, the second red light emitting portion, and the light transmitting portion.

In a light emitting display device according to one example of the present disclosure, the second light shielding pixel-defining film may have the first height around the second blue light emitting portion, and the second light shielding pixel-defining film has the second height around the second green light emitting portion, the second red light emitting portion, and the light transmitting portion.

In a light emitting display device according to one example of the present disclosure, the second light shielding pixel-defining film at the second area may comprise a region in which a boundary between the light transmitting portion and at least one of the second blue light emitting portion, the second red light emitting portion, and the second green light emitting portion has a third height lower than the second height.

A light emitting display device according to one example of the present disclosure may further comprise a planarization film between the substrate and the light emitting element. The planarization film may have a groove having a predetermined thickness from an upper surface thereof at the second blue light emitting portion, the second green light emitting portion, and the second red light emitting portion.

In a light emitting display device according to one example of the present disclosure, the light emitting element may comprise a first electrode including a reflective electrode, an intermediate layer on the first electrode and a second electrode disposed on the intermediate layer. Surface areas of the second blue light emitting portion, the second green light emitting portion, and the second red light emitting portion located on the groove may be wider than surface areas of the first blue light emitting portion, the first green light emitting portion, and the first red light emitting portion on the planarization film.

In a light emitting display device according to one example of the present disclosure, the groove may not overlap the second light shielding pixel-defining film.

In a light emitting display device according to one example of the present disclosure, the surface area of the second blue light emitting portion may be larger than the surface area of the first blue light emitting portion. The surface area of the second green light emitting portion may be larger than the surface area of the first green light emitting portion. The surface area of the second red light emitting portion may be larger than the surface area of the first red light emitting portion.

A light emitting display device according to one example of the present disclosure may further comprise a transparent pixel-defining film on each of the first light shielding pixel-defining film and the second pixel-defining film.

A light emitting display device according to one example of the present disclosure may further comprise a transistor connected to the light emitting element between the substrate and the planarization film.

In a light emitting display device according to one example of the present disclosure, the transistor may comprise an active layer including an oxide semiconductor at each of the first area and the second area.

In a light emitting display device according to one example of the present disclosure, a mobility of the active layer at the second area may be greater than the active layer at the first area.

A light emitting display device according to one example of the present disclosure may further comprise a light shielding pattern under the active layer.

In a light emitting display device according to one example of the present disclosure, the transistor may comprise a gate electrode overlapping the active layer and first and second source-drain electrodes connected to the active layer, respectively. One of the first source-drain electrode and the second source-drain electrode may be connected to the light shielding pattern.

In a light emitting display device according to one example of the present disclosure, the light emitting display device may comprise a plurality of inorganic insulating films and a plurality of planarization films between the substrate and the light emitting element. At least one of the inorganic insulating films or the planarization films may have a sidewall around the light transmitting portion.

In a light emitting display device according to one example of the present disclosure, the at least one sidewall of the inorganic insulating films and the planarization films between the substrate and the light emitting element may comprise a light shielding pixel-defining film.

As apparent from the foregoing, the light emitting display device according to examples of the present disclosure has the following effects.

Examples of the present disclosure provide a light emitting display device that exhibits improved brightness based on structural change in an area where light emitting portions and light transmitting portions are mixed.

The light emitting display device according to examples of the present disclosure is capable of preventing the effects of upper light and internally scattered light on the lower components based on the light shielding pixel-defining film disposed around the light emitting portion.

The light emitting display device according to examples of the present disclosure includes a light shielding pixel-defining film in a structure including an active layer of a high-mobility oxide semiconductor and includes a light shielding pixel-defining film having a low height in the area where the sensor or camera is disposed, thereby increasing the light transmittance of the area where the sensor and camera are disposed.

The light emitting display device according to examples of the present disclosure reduces the difference in height

between the light shielding pixel-defining film around a blue light emitting portion and a green or red light emitting portion in the area where a sensor or a camera is disposed, thereby preventing great changes in the characteristics of a high-mobility oxide semiconductor when irradiated with relatively short-wavelength light.

The light emitting display device according to examples of the present disclosure is capable of preventing light generated from an adjacent light emitting element from being transmitted to a light transmitting portion based on the light shielding pixel-defining film disposed around the light transmitting portion.

The light emitting display device according to examples of the present disclosure is capable of preventing a rapid change in brightness through a gradual thickness change of a light shielding pixel-defining film at the boundary between a light emitting portion and a light transmitting portion.

The light emitting display device according to the examples of the present disclosure is capable of responding to the high brightness characteristics required for the sensor unit because the transistors in the sensor unit have high mobility characteristics.

The light emitting display device according to the examples of the present disclosure includes a groove in the light emitting portions of the area where the sensor or the camera is disposed, thereby improving both reflection efficiency and luminous efficacy. Therefore, the light emitting display device has sustainable significance, thus realizing ESG (environmental/social/governance) goals.

The light emitting display device according to the examples of the present disclosure has a light shielding pixel-defining film, thereby preventing changes in a transistor caused by light generated from a light emitting element and reducing a defect rate of the transistor. The light emitting display device according to the examples of the present disclosure can reduce the amount of materials used throughout the manufacturing process, such as gases and etchants for manufacturing the display device because active patterns of different structures can be manufactured in the same process. Accordingly, it is possible to provide a light emitting display device capable of process optimization and reducing greenhouse gases generated due to the manufacturing process. In addition, the light emitting display device according to the examples of the present disclosure forms active layers for each area in the same process, thereby reducing processes required for additional materials, reducing production energy, and reducing greenhouse gases that may be generated through the manufacturing process through process optimization. Accordingly, it is possible to obtain the ESG (environmental/social/governance) effects through process optimization.

It will be apparent to those skilled in the art that various modifications and variations can be made in the disclosure without departing from the scope of the disclosure. Thus, it is intended that the disclosure cover such modifications and variations thereof, provided they fall within the scope of the appended claims and their equivalents.

Also disclosed are the following numbered clauses:

1. A light emitting display device comprising:

    a substrate including a first area and a second area;
    a first light shielding pixel-defining film provided at the first area, exposing a first blue light emitting portion, a first green light emitting portion, and a first red light emitting portion, and having a first height;
    a second light shielding pixel-defining film provided at the second area, including a region exposing a second blue light emitting portion, a second green light emitting portion, and a second red light emitting portion and a light transmitting portion, and including an area having a second height smaller than the first height; and
    a light emitting element on the first blue light emitting portion, the first green light emitting portion, the first red light emitting portion, the second blue light emitting portion, the second green light emitting portion, and the second red light emitting portion.

2. The light emitting display device according to clause 1, wherein the second light shielding pixel-defining film has the second height around the second green light emitting portion and the second red light emitting portion.

3. The light emitting display device according to clause 1 or 2, wherein a height of the second light shielding pixel-defining film decreases with a decreasing distance from the light transmitting portion.

4. The light emitting display device according to any preceding clause, wherein the second light shielding pixel-defining film has the second height around the second green light emitting portion, the second red light emitting portion, and the light transmitting portion.

5. The light emitting display device according to any preceding clause, wherein the second light shielding pixel-defining film has the first height around the second blue light emitting portion, and the second light shielding pixel-defining film has the second height around the second green light emitting portion, the second red light emitting portion, and the light transmitting portion.

6. The light emitting display device according to any preceding clause, wherein the second light shielding pixel-defining film at the second area comprises a region in which a boundary between the light transmitting portion and at least one of the second blue light emitting portion, the second red light emitting portion, and the second green light emitting portion has a third height lower than the second height.

7. The light emitting display device according to any preceding clause further comprising:

a planarization film between the substrate and the light emitting element,
wherein the planarization film has a groove having a predetermined thickness from an upper surface thereof at the second blue light emitting portion, the second green light emitting portion, and the second red light emitting portion.

8. The light emitting display device according to clause **7,** wherein the light emitting element comprises:

a first electrode including a reflective electrode;
an intermediate layer on the first electrode; and
a second electrode disposed on the intermediate layer,
wherein surface areas of the second blue light emitting portion, the second green light emitting portion, and the second red light emitting portion located on the groove are wider than surface areas of the first blue light emitting portion, the first green light emitting portion, and the first red light emitting portion on the planarization film; and, optionally
wherein the groove does not overlap the second light shielding pixel-defining film.

9. The light emitting display device according to any preceding clause, wherein a surface area of the second blue light emitting portion is larger than a surface area of the first blue light emitting portion,

a surface area of the second green light emitting portion is larger than a surface area of the first green light emitting portion, and
a surface area of the second red light emitting portion is larger than a surface area of the first red light emitting portion.

10. The light emitting display device according to any preceding clause, further comprising a transparent pixel-defining film on each of the first light shielding pixel-defining film and the second light shielding pixel-defining film.

11. The light emitting display device according to any one of clauses 7 to 9, further comprising:

a transistor connected to the light emitting element between the substrate and the planarization film; and, optionally
wherein the transistor comprises an active layer including an oxide semiconductor at each of the first area and the second area; and/or, optionally
wherein a mobility of the active layer at the second area is greater than a mobility of the active layer at the first area.

12. The light emitting display device according to clause 11, further comprising:
a light shielding pattern under the active layer.

13. The light emitting display device according to clause 12, wherein the transistor comprises:

a gate electrode overlapping the active layer; and
a first source-drain electrode and a second source-drain electrode connected to the active layer, respectively, wherein one of the first source-drain electrode and the second source-drain electrode is connected to the light shielding pattern.

14. The light emitting display device according to any preceding clause, further comprising a plurality of inorganic insulating films and a plurality of planarization films between the substrate and the light emitting element,
wherein at least one of the plurality of inorganic insulating films or the plurality of planarization films has a sidewall around the light transmitting portion.

15. The light emitting display device according to clause 14, wherein the sidewall of the at least one of the plurality of

inorganic insulating films and the plurality of planarization films between the substrate and the light emitting element comprises a light shielding pixel-defining film.

## Claims

**1.** A light emitting display device (1000A) comprising:

a substrate (110) including a first area (BA) and a second area (SA);
a first light shielding pixel-defining film (240A) provided at the first area (BA), exposing a first light emitting portion (BEM1), and having a first height (H1);
a second light shielding pixel-defining film (240B) provided at the second area (SA), including a region exposing a second light emitting portion (BEM2) and a light transmitting portion, and including an area having a second height (H2) smaller than the first height;
a light emitting element (ED) on the first light emitting portion (BEM1) and the second light emitting portion (BEM2); and
a plurality of inorganic insulating films (121, 122, 123, 124, 125, 126, 127, 128, 129) and a plurality of planarization films (130, 131) between the substrate (110) and the first and second light shielding pixel-defining films (240A, 240B), wherein at least one of the plurality of inorganic insulating films (121, 122, 123, 124, 125, 126, 127, 128, 129) and the plurality of planarization films (130, 131) is removed at the light transmitting portion (TA).

**2.** The light emitting display device according to claim 1, wherein the first light shielding pixel-defining film (240A) and/or the second light shielding pixel-defining film (240B) comprises a plurality of holes at a region other than at the light emitting element (ED).

**3.** The light emitting display device according to claim 2, further comprising a contact hole (CT8) to expose an upper surface of a connection electrode (181) in the plurality of planarization films (130, 131),
wherein an anode (210) of the light emitting element (ED) is connected to the connection electrode (181) through the contact hole (CT8).

**4.** The light emitting display device according to claim 3, wherein the plurality of holes at a region other than at the light emitting element (ED) overlaps a contact area between the anode (210) and a transistor (T2).

**5.** The light emitting display device according to claim 3 or 4, wherein the plurality of holes at a region other than at the light emitting element (ED) overlaps the connection electrode (181).

**6.** The light emitting display device according to claim 5, wherein the light emitting element (ED) and the transistor (T2) are connected by the connection electrode (181).

**7.** The light emitting display device according to any preceding claim, wherein the first light shielding pixel-defining film (240A) comprises opaque material containing at least one of color pigment, organic black, and carbon.

**8.** The light emitting display device according to any preceding claim, wherein a height of the second light shielding pixel-defining film (240B) decreases with a decreasing distance from the light transmitting portion.

**9.** The light emitting display device according to any preceding claim, wherein the second light shielding pixel-defining film (240B) at the second area (SA) comprises a region in which a boundary between the light transmitting portion (TA) and the second light emitting portion (BEM2) has a third height (H3) lower than the second height (H2).

**10.** The light emitting display device according to any preceding claim, wherein the plurality of planarization films (130, 131) has a groove (131R) having a predetermined thickness from an upper surface thereof at the second light emitting portion (BEM2).

**11.** The light emitting display device according to claim 10, wherein the light emitting element (ED) comprises:

a first electrode (210A) including a reflective electrode;
an intermediate layer (220) on the first electrode (210A); and
a second electrode (230) disposed on the intermediate layer (220),

wherein surface areas of the second light emitting portion (BEM2) located on the groove (131R) are wider than surface areas of the first light emitting portion (BEM1) and, optionally wherein the groove (131R) does not overlap the second light shielding pixel-defining film (240B).

**12.** The light emitting display device according to any preceding claim, further comprising a transparent pixel-defining film (250) on each of the first light shielding pixel-defining film (240A) and the second light shielding pixel-defining film (240B).

**13.** The light emitting display device according to any preceding claim when dependent on claim 5,

wherein the transistor (T2) comprises an active layer including an oxide semiconductor at each of the first area and the second area; and/or, optionally
wherein a mobility of the active layer at the second area is greater than a mobility of the active layer at the first area, and further optionally,
further comprising a light shielding pattern under the active layer.

**14.** The light emitting display device according to any preceding claim, wherein at least one of the plurality of inorganic insulating films (121, 122, 123, 124, 125, 126, 127, 128, 129) or the plurality of planarization films (130, 131) has a sidewall around the light transmitting portion (TA).

**15.** The light emitting display device according to claim 14, wherein the sidewall of the at least one of the plurality of inorganic insulating films (121, 122, 123, 124, 125, 126, 127, 128, 129) and the plurality of planarization films (130, 131) between the substrate (110) and the light emitting element (ED) comprises a light shielding pixel-defining film (240BE).

FIG. 1

1000
GL
A
SP
DL
DP
110
AA
NA

FIG. 2

DL
SP
EVDD
GL
Cst
CC
T1
N1
T2
ED
EVSS

FIG. 3

(BEM2, GEM2, REM2)
EM2
BNK2
(240B/250)
A
P2
SP2
SP3
SP1
TA
I
I'
SA
BA
SP2
SP1
SP3
P1
BNK1
(240A/250)
EM1
(BEM1, GEM1, REM1)

FIG. 4

P1_SP
P2_SP1
P2_SP2 or P2_SP3
TA
I
I'
T2
145
151
161
CT1
171
181
CT8
H1
CT7
CT2
CT3
172
230
220
210
ED
250
240A
BNK1
250
240B
BNK2
210A
131R
240BA
240BB
240BC
240B
H2
H3
110
121
122
123
124
125
126
127
128
129
130
131
200
300
1000A

FIG. 5

171
172
173
174
CT6
CT1
CT2
CT3
CT4
CT5
T2
161
162
151
152
145
141
129
128
127
126
125
124
123
122
121
110
T2
T1

# FIG. 6

T1
141
152
162
CT4
173
182
H1
CT5
CT6
174
ED
230
220
210
BNK1
250
240A
BNK2
250
240B
210
210A
131R
240BA
240BB
240B
H2
240V
P1_SP
P2_SP1
P2_SP2 or P2_SP3
KHR
TA
110
121
122
123
124
125
126
127
128
129
130
131
200
300
1000B

FIG. 7

200
110
121
122
123
124
125
126
127
128
129
130
131
152
162
173
182
H1
CT5
CT6
174
141
230 220 210
ED
250 240A
BNK1
250 240B
BNK2
210
182
174
CT6
210A
131R
240BA
240BB
240B
H2
240BC
240BE
H3
300
1000C
P1_SP
P2_SP1
P2_SP2 or P2_SP3
TA

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020240029853